Europäisches Patentamt

European Patent Office

Office européen des brevets

(11) Veröffentlichungsnummer: **0 517 134 A1**

## (12) EUROPÄISCHE PATENTANMELDUNG

(21) Anmeldenummer: **92109184.9**

(22) Anmeldetag: **01.06.92**

(51) Int. Cl.5: **H05K 9/00**

(30) Priorität: **06.06.91 DE 9106955 U**

(43) Veröffentlichungstag der Anmeldung:
**09.12.92 Patentblatt 92/50**

(84) Benannte Vertragsstaaten:
**DE FR SE**

(71) Anmelder: **SIEMENS AKTIENGESELLSCHAFT**
**Wittelsbacherplatz 2**
**W-8000 München 2(DE)**

(72) Erfinder: **Seidel, Peter**
**Mittenwalderstrasse 256**
**W-8038 Gröbenzell(DE)**

(54) **Kontaktfederstreifen.**

(57) Der Kontaktfederstreifen besteht aus einzelnen aneinandergereihten, durch Trennstege verbundenen Kontaktfedern. Die einzelne Kontaktfeder besteht aus zwei über eine Biegekante miteinander verbundenen, annähernd parallel verlaufenden Schenkeln, welche zueinander unter Vorspannung stehen.

FIG1

Rank Xerox (UK) Business Services

EP 0 517 134 A1

Die Erfindung betrifft einen Kontaktfederstreifen zum elektromagnetischen Abdichten von Gehäuseteilen eines Schirmgehäuses, wobei der Kontaktfederstreifen mit jeweils zwei der Gehäuseteile kontaktierbar ist.

Derartige Kontaktfederstreifen sind z. B. aus dem deutschen Gebrauchsmuster G 86 26 126 bekannt. Diese Kontaktfederstreifen sind durchgehend streifenförmig und in Längsrichtung gewölbt ausgebildet und besitzen an ihren Längskanten krallenartige Fortsätze.

Ein Nachteil dieser bekannten Kontaktfederstreifen besteht darin, daß sie in unterschiedlichen festen Längen hergestellt werden, was zu einem erheblichen Produktionsaufwand und zu einer großen Lagerhaltung zwingt. Ein weiterer Nachteil ist dadurch gegeben, daß eine in Längsrichtung verlaufende leichte Wölbung produktionstechnisch schwierig herstellbar ist.

Es ist nun die Aufgabe der vorliegenden Erfindung, Kontaktfederstreifen der eingangs genannten Art so auszubilden, daß diese einfach und kostengünstig herstellbar sind und in beliebigen Längen verwendbar sind. Darüberhinaus soll eine Befestigung an Gehäuseteilen möglich sein, ohne daß eine Vorleistung am Gehäuseteil selbst erbracht werden muß.

Diese Aufgabe wird erfindungsgemäß für einen Kontaktfederstreifen der eingangs genannten Art dadurch gelöst, daß der Kontaktfederstreifen aus einer Vielzahl von einzelnen, durch Trennstege miteinander verbundenen Kontaktfedern besteht, wobei die einzelne Kontaktfeder aus zwei über eine Biegekante miteinander verbundenen, annähernd parallel verlaufenden Schenkeln besteht, und wobei der erste Schenkel eben ausgebildet ist, während der zweite Schenkel mehrfach zum ersten Schenkel hin abgekantet ist, und wobei die beiden Schenkel zueinander unter Vorspannung stehen.

Durch die Vermeidung einer in Längsrichtung des Kontaktfederstreifens verlaufenden Wölbung ist der erfindungsgemäße Kontaktfederstreifen leicht herzustellen. Dadurch, daß der Kontaktfederstreifen in eine Vielzahl von einzelnen Kontaktfedern, die mittels Trennstege miteinander verbunden sind, unterteilt ist, kann der Kontaktfederstreifen gemäß der vorliegenden Erfindung in beliebiger Länge als sogenannte "Meterware" hergestellt werden. Erst kurz vor der Montage muß der Kontaktfederstreifen auf einfache Art und Weise, nämlich durch einfaches Abbrechen oder Abschneiden, auf die gewünschte Länge gebracht werden. Aufgrund der Vorspannung der beiden Schenkel kann der erfindungsgemäße Kontaktfederstreifen einfach auf eine Gehäusekante aufgeschoben werden, ohne daß am Gehäuseteil irgendwelche Vorleistungen geleistet werden müssen.

Eine zweckmäßige Weiterbildung des erfindungsgemäßen Kontaktfederstreifens ist dadurch gekennzeichnet, daß aus dem zweiten Schenkel im Bereich der Biegekante ein trapezförmiger Lappen in Richtung auf den ersten Schenkel hin herausgedrückt ist, in dessen freien Endbereich ein in Richtung zum ersten Schenkel und zur Biegekante hin weisender Widerhaken herausgedrückt ist. Dadurch wird ein unbeabsichtigtes Abziehen des Kontaktfederstreifens vom Gehäuseteil vermieden.

Eine andere zweckmäßige Weiterbildung des erfindungsgemäßen Kontaktfederstreifens ist dadurch gekennzeichnet, daß der äußere Randbereich des ersten Schenkels über seine gesamte Länge leicht einwärts gebogen ist. Durch diese Maßnahme wird ein definierter Kontakt des ersten Schenkels mit dem Gehäuseteil erreicht. Eine weitere zweckmäßige Weiterbildung des Kontaktfederstreifens gemäß der vorliegenden Erfindung ist dadurch gekennzeichnet, daß der äußere Randbereich des zweiten Schenkels über seine gesamte Länge leicht auswärts gebogen ist, so daß der Aufsteckvorgang des Kontaktfederstreifens erleichtert wird.

Nachfolgend wird die Erfindung anhand eines in der Zeichnung dargestellten Ausführungsbeispiels näher erläutert.

Es zeigt

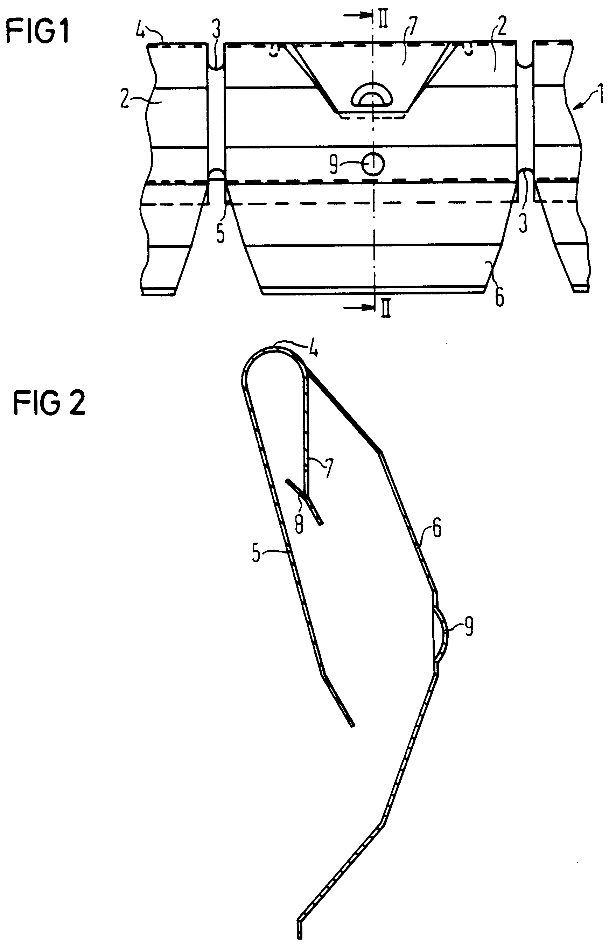

FIG 1    eine Aufsicht auf einen Teil eines gemäß der Erfindung gestalteten Kontaktfederstreifens, und

FIG 2    einen Querschnitt durch eine Kontaktfeder des in FIG 1 gezeigten Kontaktfederstreifens.

Der in der Zeichnung dargestellte Kontaktfederstreifen 1 besteht aus einer Vielzahl von über Trennstege 3 miteinander verbundenen Kontaktfedern 2. Dadurch kann der Kontaktfederstreifen "endlos" gefertigt und anschließend aufgerollt werden. Erst bei der Montage wird der Kontaktfederstreifen durch einfaches Abschneiden von der Rolle auf die gewünschte Länge gebracht. Hierdurch entfällt die Lagerhaltung unterschiedlicher Längentypen.

Nachfolgend soll die einzelne Kontaktfeder näher beschrieben werden. Die im Ausführungsbeispiel dargestellte Kontaktfeder 2 besteht aus einem ersten Schenkel 5 und einem zweiten Schenkel 6, die über eine gemeinsame Biegekante 4 miteinander verbunden sind und annähernd parallel verlaufen. Während der erste Schenkel 5 eben ausgebildet ist, ist der zweite Schenkel 6 mehrfach zum ersten Schenkel 5 hin abgekantet, um im aufgesteckten Zustand eine Federkraft zu erhalten. Im aufgesteckten Zustand des Kontaktfederstreifens befindet sich die Kante des Gehäuseteils, auf welchen der Kontaktfederstreifen gesteckt ist, zwischen den beiden Schenkeln 5 und 6 bzw. zwischen dem ersten Schenkel 5 und dem trapezförmigen Lappen 7.

Zur Vermeidung eines unbeabsichtigten Abziehens des Kontaktfederstreifens 1 vom Gehäuseteil ist ein Widerhaken 8 vorgesehen. Dieser Widerhaken weist in Richtung zum ersten Schenkel 5 und zur Biegekante 4 und ist aus einem beliebig geformten, z. B. trapezförmigen Lappen 7 herausgedrückt, welcher wiederum aus einem Teil des zweiten Schenkels 6, welcher der Biegekante 4 benachbart ist, herausgedrückt ist.

Über die Spitze dieses Widerhakens 8 ist gleichzeitig eine sichere Kontaktierung auf unedlen Oberflächen des Gehäuseteiles gewährleistet. Mit Hilfe der im Mittelbereich des zweiten Schenkels 6 angeordneten Warze 9 wird ein definierter hoher Kontaktdruck zwischen der Kontaktfeder und dem zweiten Gehäuseteil im eingeschobenen Zustand erreicht. Zur Erzielung einer besseren Kontaktierung zwischen den Kontaktfederstreifen und dem Gehäuseteil, auf welchem die Kontaktfeder aufgeschoben ist, dient auch der einwärts gebogene äußere Randbereich des ersten Schenkels 5. Für den Fall, daß bei zwei Türen zwei Kontaktfedern aufeinandertreffen, dient dieser Randbereich als Auflaufschräge.

Zur Erleichterung des Aufschiebens des Kontaktfederstreifens 1 ist der äußere Randbereich des zweiten Schenkels 6 leicht auswärts gebogen, so daß für den Aufschiebevorgang eine Gleitkante geschaffen wird.

**Patentansprüche**

1. Kontaktfederstreifen zum elektromagnetischen Abdichten von Gehäuseteilen eines Schirmgehäuses, wobei der Kontaktfederstreifen mit jeweils zwei der Gehäuseteile kontaktierbar ist, **dadurch gekennzeichnet**, daß der Kontaktfederstreifen (1) aus einer Vielzahl von einzelnen, durch Trennstege (3) miteinander verbundenen Kontaktfedern (2) besteht, wobei die einzelne Kontaktfeder (2) aus zwei über eine Biegekante (4) miteinander verbundenen, annähernd parallel verlaufenden Schenkeln (5, 6) besteht, und wobei der erste Schenkel (5) eben ausgebildet ist, während der zweite Schenkel (6) mehrfach zum ersten Schenkel (5) hin abgekantet ist, und wobei die beiden Schenkel (5, 6) zueinander unter Vorspannung stehen.

2. Kontaktfederstreifen nach Anspruch 1, **dadurch gekennzeichnet**, daß aus dem zweiten Schenkel (6) im Bereich der Biegekante (4) ein Lappen (7) in Richtung auf den ersten Schenkel (5) hin herausgedrückt ist, in dessen freien Endbereich ein in Richtung zum ersten Schenkel (5) und zur Biegekante (4) hin weisender Widerhaken (8) herausgedrückt ist.

3. Kontaktfederstreifen nach einem der vorhergehenden Ansprüche, **dadurch gekennzeichnet**, daß der äußere Randbereich des ersten Schenkels (5) zur Bildung einer Auflaufschräge über seine gesamte Länge leicht einwärts gebogen ist.

4. Kontaktfederstreifen nach Anspruch 1 oder 2, **dadurch gekennzeichnet**, daß der äußere Randbereich des zweiten Schenkels über seine gesamte Länge leicht auswärts gebogen ist.

FIG 1

FIG 2

| Europäisches Patentamt | EUROPÄISCHER RECHERCHENBERICHT | Nummer der Anmeldung EP 92 10 9184 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 425 193 (INTERNATIONAL BUSINESS MACHINES) * Spalte 6, Zeile 15 - Spalte 7, Zeile 38; Abbildungen 3-5 * --- | 1-4 | H05K9/00 |
| A | GB-A-2 183 920 (MORGAN MARINE LTD) * Seite 1, Zeile 122 - Seite 2, Zeile 8; Abbildungen 1,2 * --- | 1-4 | |
| A | DE-U-9 013 483 (CHERN, DER LUH) * Seite 5, Absatz 3 - Seite 7, Absatz 1; Abbildungen 2,3,6 * --- | 1 | |
| D,A | DE-U-8 626 126 (SIEMENS AG) ----- | | |

| | | | RECHERCHIERTE SACHGEBIETE (Int. Cl.5) |
|---|---|---|---|
| | | | H05K |

Der vorliegende Recherchenbericht wurde für alle Patentansprüche erstellt

| Recherchenort | Abschlußdatum der Recherche | Prüfer |
|---|---|---|
| DEN HAAG | 29 SEPTEMBER 1992 | RUBENOWITZ A. |